# EUROPÄISCHE PATENTSCHRIFT

(11) **EP 3 506 496 B1**
(45) Veröffentlichungstag und Bekanntmachung des Hinweises auf die Patenterteilung: **09.09.2020**
(21) Anmeldenummer: 18208310.5
(22) Anmeldetag: 22.04.2014
(51) Int. Cl.: H03B 5/18

(54) **SENSORSYSTEM MIT EINER MEHRZAHL VON BEWEGUNGS- UND/ODER ANWESENHEITS-SENSORVORRICHTUNGEN NACH DEM DOPPLER PRINZIP**
SENSOR SYSTEM WITH A PLURALITY OF MOTION AND/OR PRESENCE SENSOR DEVICES USING DOPPLER PRINCIPLE
SYSTÈME DE DÉTECTION COMPRENANT UNE PLURALITÉ D'APPAREILS DE DÉTECTION DE MOUVEMENT ET/OU DE PRÉSENCE UTILISANT LE PRINCIPE DOPPLER

(30) Priorität: 08.05.2013 DE 102013104793
(43) Veröffentlichungstag der Anmeldung: 03.07.2019
(62) Teilanmeldung aus: 14165483.0
(73) Patentinhaber: STEINEL GmbH, 33442 Herzebrock (DE)
(72) Erfinder: Eisele, Dr. Thomas, 52159 Roetgen-Rott (DE)
(74) Vertreter: Müller Hoffmann & Partner

(56) Entgegenhaltungen:
- JP-A- H1 141 031
- JP-A- H10 242 755
- JP-A- 2003 087 052
- US-A- 4 149 127
- US-A- 4 539 530
- US-A- 4 565 979
- US-A- 5 473 287
- US-B1- 6 756 936

## Beschreibung

Die vorliegende Erfindung betrifft ein Sensorsystem mit einer Mehrzahl von Hochfrequenz-Oszillatorvorrichtungen.

Oszillatorvorrichtungen sind aus dem Stand der Technik allgemein bekannt und werden für eine Vielzahl von Anwendungen eingesetzt.

Ein Beispiel für eine Verwendung von Oszillatorvorrichtungen ist der Einsatz als Lokaloszillator für eine Bewegungs- und/oder Anwesenheitssensorvorrichtung. Bei einer solchen, wiederum als bekannt vorauszusetzenden Sensorvorrichtung wird dabei über entsprechende Mischereinheiten das mit der Oszillatorvorrichtung erzeugte Lokaloszillatorsignal sende- und empfangsseitig zur Realisierung der Sensorfunktionalität verwendet, wobei derartige Sensoren typischerweise nach dem Doppler-Prinzip funktieren.

Insbesondere unter dem Gesichtspunkt einer kostengünstiger Großserienfertigung ist es dabei bekannt, eine (gattungsbildende) Oszillatorbaugruppe sowie weitere Hochfrequenz-Komponenten auf einer Leiterplatte vorzusehen, wobei typischerweise eine Mikrostreifenleitertechnologie Verwendung findet. In Verbindung mit gängigen Oszillatortopologien, etwa eines geeignet mit einem Schwingkreis rückgekoppelten verstärkenden Bauelements oder einer Baugruppe mit einem (in einem Kennlinienabschnitt vorliegenden) negativen Widerstandsverhaltens im interessierenden Frequenzbereich lassen sich so entsprechend einem Anwendungsfall geeignete Oszillatorbaugruppen realisieren.

Als aus dem Stand der Technik allgemein bekannt vorauszusetzen ist zudem eine einen (Hochfrequenz-) Bipolartransistor aufweisende Topologie in Kollektorschaltung, welche eine geeignete frequenzbestimmende Baugruppe, z.B. ein Resonatorelement oder eine Leiterstrecke (als Mikrostreifenleitung) geeignet an den Bipolartransistor gekoppelt vorsieht, wobei dies typischerweise mittels eines Koppelkondensators od.dgl. Koppelkapazität geschieht.

Während derartige Oszillatoren ein prinzipiell zuverlässiges und auch für den Anwendungsfall "Doppler-Bewegungssensor" günstiges Schwingungsverhalten aufweisen, bietet jedoch gerade eine derartige mittelbare (d.h. mittels der Kapazität bewirkte) Ankopplung das Problem hinreichend genau bestimmter bzw. genau bestimmbarer Schwingungsfrequenz. Prinzipbedingt wirken sich nämlich Bauteile- bzw. Herstellungstoleranzen des üblicherweise verwendeten Kondensatorbauelements signifikant auf die Schwingungsfrequenz (im Weiteren auch Grundfrequenz bzw., da invariabel, auch Festfrequenz genannt) aus, so dass derartige, konventionelle Oszillatorbaugruppen nach der Fertigung typischerweise eine Trimmung bzw. Kalibrierung (z.B. durch punktuellen Flächenabtrag an einem frequenzwirksamen Leiterstück der Resonatorstrecke auf der Leiterplatte) benötigen. Gerade für die Großserienfertigung ist dies jedoch mühsam und aufwendig (da üblicherweise auch ein messtechnisches Erfassen einer tatsächlichen Schwingungsfrequenz erfolgen muss), so dass im Hinblick auf den Aufwand und die Kosten einer Großserienfertigung nicht unbeträchtlicher Verbesserungsbedarf existiert.

Im Kontext bevorzugter Verwendungen derartiger Oszillatorvorrichtungen als Bewegungs- bzw. Anwesenheitssensoren entsteht zudem das Problem, dass, etwa bei einem Einsatz derartiger Bewegungs- bzw. Anwesenheitssensoren zur bewegungsgesteuerten Aktivierung von Leuchten od.dgl. elektrischen Aggregaten, üblicherweise eine Mehrzahl von Sensoren (welche dann entweder jeweils einzelnen zugehörigen Leuchten, oder aber einer gemeinsamen Beleuchtungsanlage zum Aktivieren zugeordnet sind) so an oder in einem Erfassungsbereich montiert sind, dass eine gegenseitige Beeinflussung benachbarter Bewegungs- bzw. Anwesenheitssensoren nicht vollständig vermieden werden kann. Mit anderen Worten, es entsteht eine mögliche Situation, dass ein Hochfrequenz-Empfangsteil eines Doppler-Bewegungssensors nicht etwa das eigene Sendesignal, sondern das Sendesignal eines benachbarten Sensors empfängt und so ungeplante Detektionszustände entstehen.

Der Stand der Technik weist diesbezüglich Lösungsansätze aus, etwa dergestalt, dass die jeweiligen Sensoren mit (typischerweise manuell betätigbaren) Trimmern od.dgl. Einstellelementen versehen sind, welche das Einrichten insbesondere benachbart zueinander vorzusehender Sensoren auf nicht-identische Grundschwingungen vorsieht. Allerdings erfordert diese Vorgehensweise Fachkenntnis beim Einrichten und bedeutet erhöhten Montage- und Einrichtungsaufwand.

Aus der JP 2003 087052 A ist eine Hochfrequenz-Oszillatorvorrichtung mit einer auf einer Leiterplatte vorgesehenen, einen Transistor sowie Resonatormittel aufweisenden Resonatorstrecke, die für einen Oszillatorbetrieb der Oszillatorvorrichtung auf einer Festfrequenz eingerichtet ist, bekannt. Ferner ist eine derartige Vorrichtung aus der JP H10 242755 A bekannt, wobei hier ein entlang einer eine Resonatorstrecke ausbildenden Mikrostreifenleitung Resonatormittel in Form eines koaxialen Keramikresonators koppelnd vorgesehen sind.

Aus der US 4,565,979 A ist ein doppeldielektrischer Resonator mit unteren und oberen zylindrischen dielektrischen Elementen vorgesehen, welche verwendet werden, um einen Oszillatorbetrieb im Mikrowellenbereich zu stabilisieren.

Die US 4,565,979 A beschreibt einen Mikrowellenoszillator mit einem Transistor. Ein Mikrowellenoszillator mit einem Transistor umfasst einen Resonator, welcher an den Transistor gekoppelt ist, und einen Rückkopplungskondensator, welcher eine Basisoszillationsfrequenz und Oberwellen davon erzeugt.Der Rückkopplungskondensator ist innerhalb eines Wellenleiters angeordnet und koppelt die Oszillationen in den Wellenleiter ein. Auch die JP H11 41031 A zeigt eine Oszillatorvorrichtung mit einer Anpassleitung. Die US 4,149,127 A beschreibt einen dielektrischen resonatorstabilisierten Mikrostreifenoszillator. Die US 6,756,936 B1 beschreibt einen planaren Mikrowellenbewegungssensor mit einem Oszillator und einem Feldeffekttransistor. Die US 5,473,287 A beschreibt einen elektronischen Oszillator mit einer Übertragungsleitungsanpassung des Phasenrauschens und Linearität.

Aufgabe der vorliegenden Erfindung ist es daher, bei einem Sensorsystem eine Hochfrequenz-Oszillatorvorrichtung, insbesondere zur Verwendung als Lokaloszillator für einen Hochfrequenz-Bewegungs- und/oder Anwesenheitssensor, im Hinblick auf ihre Herstellungs- und Fertigungseigenschaften zu verbessern, dabei insbesondere eine hohe Reproduzierbarkeit einer Grundfrequenz (Festfrequenz) des Oszillators mit geringer Streuung innerhalb einer hergestellten Serie sicherzustellen und insbesondere ein jeweiliges Messen und Trimmen der hergestellten Oszillatorvorrichtungen (bzw. der damit realisierten Hochfrequenz-Baugruppen) obsolet zu machen. Gleichzeitig ist es Aufgabe der vorliegenden Erfindung bei einem Sensorsystem eine herstellungstechnisch einfache Möglichkeit dafür zu schaffen, dass eine Variation von Grundfrequenzen einer Mehrzahl der Oszillatorvorrichtungen mit geringem Aufwand ermöglicht ist, mit dem Ziel, bereits mit der Fertigung und ohne die Notwendigkeit individueller Einstellungen eines Bewegungs- bzw. Anwesenheitssensors am Einsatzort eine gegenseitige (und unerwünschte) Beeinflussung einander im jeweiligen Erfassungsbereich benachbarter oder überlappender Sensoren zu vermeiden.

Diese Aufgabe wird durch das Sensorsystem gemäß Anspruch 1 gelöst. Vorteilhafte Ausgestaltungen und Weiterbildungen der Erfindung sind in den Unteransprüchen angegeben.

### Das Sensorsystem weist eine Mehrzahl von

Bewegungs- bzw. Anwesenheitssensorvorrichtung en mit einer Hochfrequenz-Oszillatorvorrichtung auf , wobei wiederum ein derartiger Anwesenheits- bzw. Bewegungssensor vorteilhaft zur bewegungsgesteuerten Aktivierung elektrischer Verbraucher, etwa in der Art einer Sensorleuchte, verwendet werden kann. Insbesondere wird die Aufgabe durch ein Sensorsystem gelöst das eine Mehrzahl derartiger lösungsgemäßer Bewegungs- bzw. Anwesenheitssensorvorrichtungen aufweist , wobei lösungsgemäß die einander benachbart bzw. in einem überlappenden Sensor-Erfassungsbereich vorzusehenden Sensorvorrichtungen jeweilige Hochfrequenz-Oszillatorvorrichtungen aufweisen, welche, durch Variation einer Längserstreckung der jeweiligen Mikrostreifenleitungen zur Ankopplung der Resonatormittel, in herstellungstechnisch günstiger und reproduzierbarer Weise eine Variation in der Schwingungs-Grundfrequenz erfahren haben (gerade auch im Hinblick etwa auf Resonatorbauelemente einer Frequenz).

In erfindungsgemäß vorteilhafter Weise ist zunächst vorgesehen, dass die erfindungsgemäßen keramischen Resonatormittel an einem ersten Ende der Resonatorstrecke, welche weiter bevorzugt auf eine Länge von 3/2 Lambda der Grundfrequenz (Festfrequenz) eingerichtet ist, vorgesehen ist. Diese Resonatormittel, welche weiter bevorzugt im Rahmen der Erfindung als koaxialer Keramikresonator ausgebildet sind, werden erfindungsgemäß vorteilhaft über eine Anpassleitung als Mikrostreifenleitung mit der Basis des Bipolartransistors verbunden, so dass, vom keramischen Resonator zum Transistor, eine praktisch reflexions- und verlustfreie hochfrequente Wellenführung entsteht.

In der konkreten Realisierung als Kollektorschaltung verläuft dabei die Resonatorstrecke von der Basis des (Hochfrequenz-) Bipolartransistors über den Kollektor bis zu einem mittels der zweiten Mikrostreifenleitung ausgebildeten, das zweite Ende realisierenden Leitungsabschnitt ("radiales Leitungsende"), so dass unter Nutzung der Mikrostreifenleitungstechnologie und damit herstellungstechnisch günstig und großserientauglich ein erfindungsgemäßer Oszillator realisierbar ist. Gleichzeitig sorgen die am ersten Ende der Resonatorstrecke erfindungsgemäß vorgesehenen keramischen Resonatormittel für einen doppelten Vorteil etwa gegenüber einer (reinen) Streifenleitung: Zum einen bewirkt insbesondere der vorteilhaft und weiterbildungsgemäß eingesetzte keramische Koaxialresonator eine verbesserte Oszillatorgüte, zum anderen ist durch das Vorsehen derartiger keramischer Resonatormittel eine effektive räumliche bzw. geometrische Verkürzung der Resonatorstrecke erreichbar: Bei einer für die praktische Realisierung der vorliegenden Erfindung typischen Grundfrequenz (Festfrequenz) von 5,8 GHz mit einer Wellenlänge von ca. 26 mm auf dem gewählten Substrat würde eine 1/2 Lambda Resonatorstrecke ca. 13 bis 14 mm Mikrostreifen-Leiterlänge erfordern. Durch die Verwendung eines koaxialen Keramikresonators verkürzt sich diese Länge auf ca. 4 mm, mit den dadurch erreichten Vorteilen der Kompaktheit der Oszillatorvorrichtung (und optimierten Einflusses durch eine Ätzgenauigkeit in der Fertigung).

Mit der erfindungsgemäßen Anpassleitung ist damit die Voraussetzung geschaffen, erfindungsgemäß vorteilhaft die (keramischen) Resonatormittel ohne Koppelkondensator bzw. Koppelkapazität an den Bipolartransistor anzukoppeln, so dass der mit den Bauteiletoleranzen üblicher Kopplerkondensator verbundene Mess- und Trimmaufwand entfällt. Vielmehr hat sich vorteilhaft herausgestellt, dass sich in der erfindungsgemäß vorgesehenen Weise hochgradig reproduzierbare Schwingungseigenschaften (betreffend die erreichte Grund- bzw. Festfrequenz) erzielen lassen, ohne die Notwendigkeit einer Einzelvermessung und -justierung in der Serienfertigung.

Diese erfindungsgemäße Ankoppelung bietet weiterbildungsgemäß zusätzlich den Vorteil, in herstellungstechnisch einfacher Weise eine gewünschte Schwingungsfrequenz-Variation der Hochfrequenz-Oszillatorvorrichtung zu erreichen, mit der oben geschilderten Absicht, einander benachbart vorzusehende Bewegungssensoren od.dgl. Hochfrequenzeinheiten (welche jeweils die erfindungsgemäße Hochfrequenz-Oszillatorvorrichtung einsetzen) ohne die Gefahr gegenseitiger Beeinflussung in einem gegenseitigen Erfassungsbereich betreiben zu können. Erfindungsgemäß ist dies dadurch ermöglicht, dass lediglich durch die Längenvariation der Anpassleitung (zwischen den keramischen Resonatormitteln und der Basis des Bipolartransistors) eine derartige reproduzierbare Frequenzbeeinflussung erreicht werden kann. Im typischen Anwendungsfall einer Grundfrequenz im Bereich von 5,8 GHz und der auf eine Länge von ca. 1/4 Lambda eingerichteten Anpassleitung (entsprechend ca. 7 mm Länge, bei typischer Mikrostreifen-Leitungsbreite von ca. 0,13 mm) würde bereits eine Längenvariation diese 7 mm-Strecke um +/- 0,2 mm, also um typischerweise ca. 2 bis 4 %, ausreichen, um einen hinreichenden Abstand der jeweils erreichten Grundfrequenz zu erzeugen. Gleichzeitig wirken sich derartige Variationen nicht kritisch auf ein hochfrequenzmäßiges Anpass- bzw. Reflexionsverhalten in diesem ersten Endbereich der Resonatorstrecke aus.

Durch das erfindungsgemäße Vorsehen der keramischen Resonatormittel (1/2 Lambda), der Anpassleitung (1/4 Lambda) sowie einer daran anschließenden Mikrostreifenleitung als Zuleitung (1/4 Lambda) zum Bipolartransistor, in Verbindung mit einem 1/2 Lambda Leitungsabschnitt zum zweiten Ende der Resonatorstrecke entsteht so eine Gesamtlänge von 3/2 Lambda, welche für hin- und rücklaufende Wellen (zwischen dem ersten und dem zweiten Ende) ein sich überlagerndes Wellenmaximum an der Basis des Bipolartransistors ermöglicht. Dieses sorgt wiederum für eine Aufsteuerung der Transistors. Emitterseitig erfolgt die Auskopplung eines Teils der Schwingungsenergie für nachzuschaltende Aggregate und Funktionseinheiten, wobei der Emitter des Bipolartransistors so mit einer Impedanz beschaltet ist, dass (nicht-ausgekoppelte) Energie zurück in die Resonatorstrecke reflektiert wird und sich wie oben überlagert.

Im Ergebnis wird durch die vorliegende Erfindung in überraschend einfacher und eleganter Weise das zugrundliegende Problem gelöst, eine großserientaugliche Fertigung von Hochfrequenz-Oszillatorvorrichtungen, insbesondere zum Einsatz in Bewegungs- bzw. Anwesenheitssensoren, signifikant zu vereinfachen, dabei Reproduzierbarkeit im Schwingungsverhalten zu erhöhen und Streuungen zu vermindern bzw. bauteilebedingte Toleranzeffekte faktisch auszuschließen. Entsprechend ist die vorliegende Erfindung günstig als Lokaloszillator für die beanspruchte Verwendung geeignet, ist jedoch gleichwohl nicht auf diesen Verwendungszweck beschränkt, sondern eignet sich für jeglichen Anwendungsfall einer Hochfrequenz-Oszillatorvorrichtung, bei welchem diese skizzierten Vorteile unmittelbaren Herstellungs- und Gebrauchsnutzen bringen.

Weitere Vorteile, Merkmale und Einzelheiten der Erfindung ergeben sich aus der nachfolgenden Beschreibung bevorzugter Ausführungsbeispiele sowie anhand der Zeichnungen; diese zeigen in:
- Fig. 1:: ein Schemaschaubild zum Illustrieren des Aufbaus der erfindungsgemäßen Resonatorstrecke samt Verstärkerhalbleiter im Rahmen eines bevorzugten Ausführungsbeispiels der Erfindung in Form von zusammenwirkenden Funktionskomponenten;
- Fig. 2:: eine Leiterplatten-Layoutdarstellung des Ausführungsbeispiels der Fig. 1 mit Anordnung und Verschaltung der verwendeten Komponenten;
- Fig. 3:: ein der Realisierung der Fig. 1, 2 entsprechendes Schaltbild und
- Fig. 4:: ein Schemadiagramm zum Verdeutlichen der Hochfrequenz-Wellenführung in der Implementierung der Fig. 2.

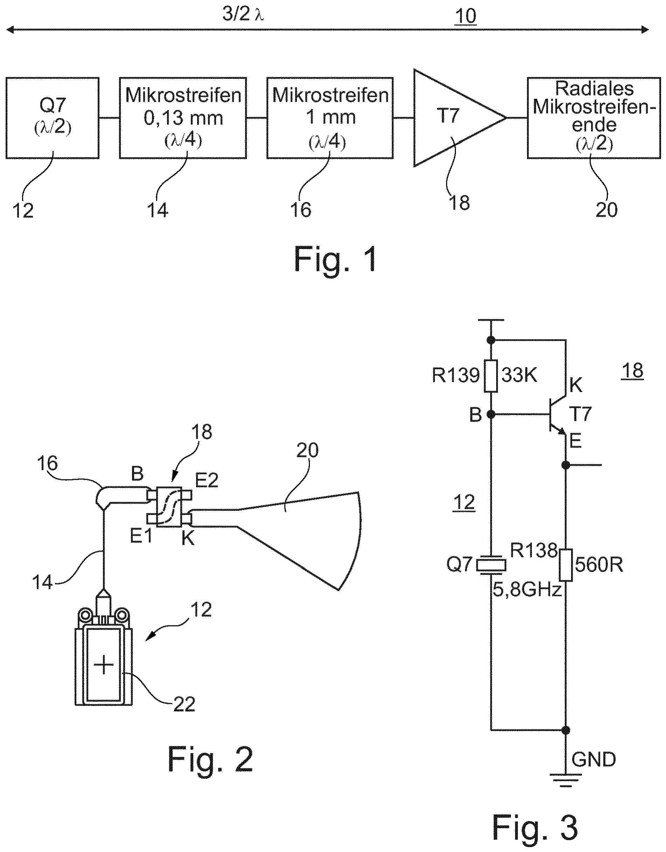

Die Fig. 1 zeigt in der schematischen Ansicht die Zusammensetzung der Resonatorstrecke 10 aus ihren Funktionskomponenten: Einends, und realisiert durch einen koaxialen Keramikresonstor (Q7) 12, wird ein erster Streckenabschnitt der Länge 0,5 x Lambda realisiert. An diesen schließt sich als Anpassleitung 14 ein Streifen einer Mikrostreifenleitung einer Länge von ca. 7 mm bei einer Breite von ca. 0,13 mm an, realisiert so selbst eine Länge von 0,25 x Lambda. Über einen weiteren, verbreiterten Mikrostreifenleitungsabschnitt 16 (wiederum Länge 0,25 x Lambda) erfolgt die Verbindung mit der Basis des Bipolartransistors 18 (T7 im Schaltbild), an welchen sich kollektorseitig ein Streifenleitungsabschnitt 20 mit einem offenen Leitungsende (im Layout der Fig. 2 aufgefächert) anschließt, zur Realisierung eines weiteren Leitungsabschnitts der Länge 0,5 x Lambda. Die vergrößerte Darstellung der Fig. 2 überträgt diese schematischen Funktionskomponenten auf das Leiterplattenlayout, wobei der (Hochfrequenz-) Bipolartransistor, in einem SMD-fähigen Gehäuse gezeigt, einen doppelten Emitteranschluss E1, E2 aufweist und (in den Figuren nicht gezeigt) an E1 die (teilweise) Auskopplung der Oszillatorenergie für nachgeschaltete Schaltungskomponenten, etwa sende- und empfangsseitige Mischer, erfolgt.

Deutlich erkennbar ist im Layout der Fig. 2, dass die Mikrostreifenleitungen 14, 16 zueinander rechtwinklig abgewinkelt sind, und es wird deutlich, dass ein weiterbildungsgemäßes Verlängern bzw. Verkürzen der Anpassleitung 14 mit dem Zweck einer Frequenzvariation bei der Leiterplattenherstellung lediglich ein (in der Fig. 2 dann vertikales) Verschieben einer Resonatoraufnahme 22 für den Koaxialresonator 12 bedingt, bevorzugt im Bereich von weniger als ca. 0,2 mm (Basis für sämtliche Dimensionsangaben ist eine Grundfrequenz von 5,8 GHz).

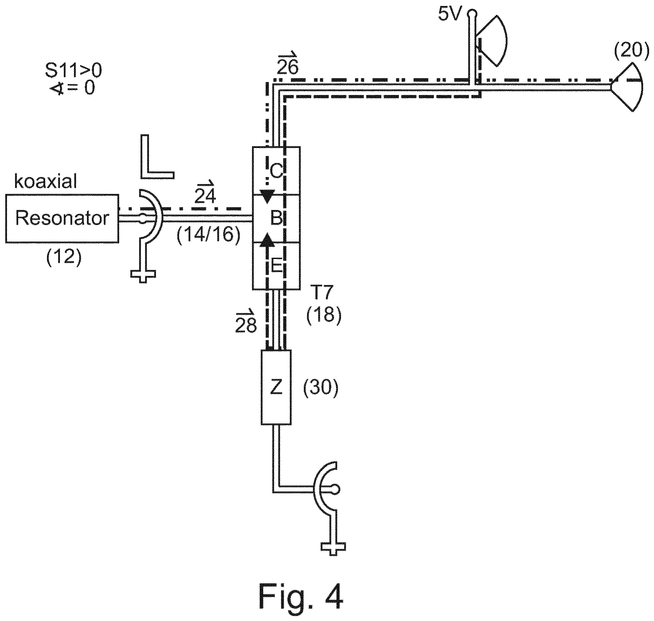

Während das formale Schaltbild der Fig. 3 den Schaltungskontext der Kollektorschaltung verdeutlicht (ohne dass die Mikrostreifenleitungs-Realisierung in den Fig. 1, 2 im Detail gezeigt wird), verdeutlicht das Schemadiagramm der Fig. 4 mit durch Pfeile verdeutlichten Verläufen der hin- und rücklaufenden Wellen die Funktion bzw. das Schwingungsverhalten der Ausführungsform der Fig. 1 und 2. An der Basis des Transistors 18 überlagert sich eine vom Koaxialresonator 12 über die Leitungsanordnung 14, 16 zur Basis laufenden hinlaufenden Welle (Pfeil 24) mit einer vom offenen Streifenende (der Streifenleitung 20) reflektierten rücklaufenden Welle, Pfeil 26. Ein entlang der Kollektor-Emitterstrecke fließender Kollektorstrom wird emitterseitig (teilweise) ausgekoppelt, teilweise reflektiert (Pfeilverlauf 28). Ein emitterseitig vorgesehenes komplexes Anpassnetzwerk 30 (in den Fig. 1 bis 3 nicht gezeigt) ist so eingerichtet, dass die Welle 28, mit Wellenmaximum der stehenden Welle an Basis B bzw. Emitter E des Transistors 18, in die Resonatorstrecke reflektiert wird.

## Patentansprüche

1. Sensorsystem, aufweisend eine Mehrzahl von Bewegungs- und/oder Anwesenheitssensorvorrichtungen, wobei eine Bewegungs- und/oder Anwesenheitssensorvorrichtung eine Hochfrequenz-Oszillatorvorrichtung als Lokaloszillator der nach dem Dopplerprinzip realisierten Sensorvorrichtung aufweist, mit
einer auf einer Leiterplatte vorgesehenen, einen Bipolartransistor (18) sowie keramische Resonatormittel (12) aufweisenden Resonatorstrecke (10), die für einen Oszillatorbetrieb der Oszillatorvorrichtung auf einer Festfrequenz eingerichtet ist, wobei die ein erstes Ende der Resonatorstrecke ausbildenden Resonatormittel auf der Leiterplatte über eine als erste Mikrostreifenleitung (14) realisierte Anpassleitung mit der Basis (B) des Bipolartransistors verbunden sind, und der Bipolartransistor so beschaltet ist, dass im Oszillatorbetrieb an der Basis ein Wellenmaximum einer sich überlagernden hin- (24) und rücklaufenden (26) stehenden Welle entlang der Resonatorstrecke vorliegt, wobei eine erste Anpassleitung der Hochfrequenz-Oszillatorvorrichtung einer ersten der Bewegungs- bzw. Anwesenheitssensorvorrichtung eine Länge der Mikrostreifenleitung aufweist, die sich von der Länge der Mikrostreifenleitung einer zweiten der Bewegungs- bzw. Anwesenheitssensorvorrichtung unterscheidet, und wobei eine Längenvariation der Anpassleitungen eine Schwingungsfrequenz-Variation der Hochfrequenz-Oszillatorvorrichtungen erzeugt.

2. System nach Anspruch 1, **dadurch gekennzeichnet, dass** die Resonatormittel und ohne eine Koppelkapazität, insbesondere ohne einen Koppelkondensator, an den Bipolartransistor angekoppelt sind.

3. System nach Anspruch 1 oder 2, **dadurch gekennzeichnet, dass** die Resonatormittel einen koaxialen Keramikresonator (12, Q7) aufweisen, der endseitig der Anpassleitung auf der Leiterplatte vorgesehen ist.

4. System nach einem der vorstehenden Ansprüche, **dadurch gekennzeichnet, dass** die Resonatorstrecke auf eine hochfrequenzmäßig wirksame Länge von 3/2 oder eines ganzzahligen vielfachen einer Hälfte der Wellenlänge der Festfrequenz eingerichtet ist.

5. System nach einem der vorstehenden Ansprüche, **dadurch gekennzeichnet, dass** zum Ausbilden eines zweiten Endes der Resonatorstrecke ein als zweite Mikrostreifenleitung (20) ausgebildeter Leitungsabschnitt einer hochfrequenzmäßig wirksamen Länge von 1/2 der Wellenlänge der Festfrequenz mit dem Kollektor (K) des Bipolartransistors verbunden ist.

6. System nach einem der vorstehenden Ansprüche, **dadurch gekennzeichnet, dass** eine Auskopplung eines Oszillator-Ausgangssignals der Oszillatorvorrichtung über den Emitter (E) des Bipolartransistors, bevorzugt über eine Koppelkapazität, erfolgt.

7. System nach einem der vorstehenden Ansprüche, **dadurch gekennzeichnet, dass** der Längenunterschied weniger als 4 %, bevorzugt weniger als 2 %, bezogen auf die größte Länge der Mikrostreifenleitungen beträgt und/oder die sich unterscheidenden Längen auf einen Bereich zwischen 0,96 x Lambda/4 und 1,04 x Lambda/4 eingerichtet sind, wobei Lambda die Wellenlänge einer mittleren der Festfrequenzen der jeweiligen Hochfrequenz-Oszillatorvorrichtungen ist.

## Claims

1. A sensor system, having a plurality of motion and/or presence sensor devices, wherein a motion and/or presence sensor device has a high-frequency oscillator device as a local oscillator of the sensor device embodied according to the Doppler principle, with
a resonator path (10) provided on a printed circuit board and having a bipolar transistor (18) as well as ceramic resonator means (12), which path is configured for oscillator operation of the oscillator device at a fixed frequency, wherein the resonator means forming a first end of the resonator path on the printed circuit board are connected, on the printed circuit board, to the base (B) of the bipolar transistor via a matching line produced as a first microstrip line (14) and the bipolar transistor is connected such that, during oscillator operation, a wave maximum of a superposing forward (24) and reflective (26) standing wave along the resonator path is located at the base, wherein a first matching line of the high-frequency oscillator device of a first motion or presence sensor devices has a length of the microstrip line which differs from the length of the microstrip line of a second motion or presence sensor device, and wherein a variation in length of the matching lines generates an oscillation frequency variation of the high-frequency oscillator devices.

2. The system according to claim 1, **characterised in that** the resonator means are coupled to the bipolar transistor without a coupling capacitance, in particular without a coupling capacitor.

3. The system according to claim 1 or 2, **characterised in that** the resonator means have a coaxial ceramic resonator (12, Q7) which is provided at the end of the matching line on the printed circuit board.

4. The system according to one of the preceding claims, **characterised in that** the resonator path is configured to a high-frequency effective length of 3/2 or of an integer multiple of a half of the wavelength of the fixed frequency.

5. The system according to one of the preceding claims, **characterised in that**, to form a second end of the resonator path, a line section formed as a second microstrip line (20), of a high-frequency effective length of 1/2 of the wavelength of the fixed frequency, is connected to the collector (K) of the bipolar transistor.

6. The system according to one of the preceding claims, **characterised in that** an oscillator output signal of the oscillator device is coupled out via the emitter (E) of the bipolar transistor, preferably via a coupling capacitance.

7. The system according to one of the preceding claims, **characterised in that** the difference in length is less than 4%, preferably less than 2%, relative to the greatest length of the microstrip lines, and/or the differing lengths are configured to a range between 0.96 x lambda/4 and 1.04 x lambda/4, wherein lambda is the wavelength of an average of the fixed frequencies of the respective high-frequency oscillator devices.

## Revendications

1. Système de détection présentant une pluralité de dispositifs de détection de mouvement et/ou de présence, dans lequel un dispositif de détection de mouvement et/ou de présence présente un dispositif oscillateur haute fréquence comme oscillateur local du dispositif de détection réalisé selon le principe du doppler, avec
une trajectoire de résonateur (10) prévue sur une carte de circuits imprimés, présentant un transistor bipolaire (28) ainsi que des moyens de résonance céramiques (12) qui est aménagée pour un mode d'oscillation du dispositif oscillateur à une fréquence fixe, dans lequel les moyens de résonance réalisant une première extrémité de la trajectoire de résonateur sur la carte de circuits imprimés sont reliés par une ligne d'adaptation réalisée comme première ligne à microrubans (14) à la base (B) du transistor bipolaire, et le transistor bipolaire est câblé de sorte qu'en mode d'oscillation sur la base un maximum d'onde d'une onde stationnaire, se déplaçant en aller (24) et retour (26) se chevauchant, se présente le long de la trajectoire de résonateur, dans lequel une première ligne d'adaptation du dispositif oscillateur haute fréquence d'un premier du dispositif de détection de mouvement ou de présence présente une longueur de la ligne à microrubans qui se distingue de la longueur de la ligne à microrubans d'un second du dispositif de détection de mouvement ou de présence, et dans lequel une variation de longueur des lignes d'adaptation génère une variation de fréquence d'oscillation des dispositifs oscillateurs haute fréquence.

2. Système selon la revendication 1, **caractérisé en ce que** les moyens de résonance sont couplés sans capacité de couplage, en particulier sans condensateur de couplage, au transistor bipolaire.

3. Système selon la revendication 1 ou 2, **caractérisé en ce que** les moyens de résonance présentent un résonateur céramique (12, Q7) coaxial qui est prévu côté extrémité de la ligne d'adaptation sur la carte de circuits imprimés.

4. Système selon l'une des revendications précédentes, **caractérisé en ce que** la trajectoire de résonateur est aménagée sur une longueur active selon la haute fréquence de 3/2 ou un multiple entier d'une moitié de la longueur d'onde de la fréquence fixe.

5. Système selon l'une des revendications précédentes, **caractérisé en ce que** pour la réalisation d'une seconde extrémité de la trajectoire de résonateur une section de ligne réalisée comme seconde ligne à microrubans (20) d'une longueur active selon la haute fréquence d'1/2 de la longueur d'onde de la fréquence fixe est reliée au collecteur (K) du transistor bipolaire.

6. Système selon l'une des revendications précédentes, **caractérisé en ce qu'**un découplage d'un signal de sortie d'oscillateur du dispositif oscillateur est effectué par le biais de l'émetteur (E) du transistor bipolaire, de préférence par une capacité de couplage.

7. Système selon l'une des revendications précédentes, **caractérisé en ce que** la différence de longueur s'élève à moins de 4%, de préférence à moins de 2%, par rapport à la longueur la plus grande des lignes à microrubans et/ou les longueurs se distinguant sont aménagées sur une zone entre 0,96 x Lambda/4 et 1,04 x Lambda/4, dans lequel Lambda est la longueur d'onde d'une médiane des fréquences fixes des dispositifs oscillateurs haute fréquence respectifs.
